# EUROPÄISCHE PATENTSCHRIFT

(11) **EP 2 872 666 B1**
(45) Veröffentlichungstag und Bekanntmachung des Hinweises auf die Patenterteilung: **22.12.2021**
(21) Anmeldenummer: 13735196.1
(22) Anmeldetag: 29.06.2013
(51) Int. Cl.: C23C 14/34, H01J 37/34

(54) **HOCHLEISTUNGSIMPULSBESCHICHTUNGSVERFAHREN**
HIGH-POWER PULSE COATING METHOD
PROCÉDÉ DE REVÊTEMENT PAR IMPULSION HAUTE PUISSANCE

(30) Priorität: 10.07.2012 DE 102012013577
(43) Veröffentlichungstag der Anmeldung: 20.05.2015
(73) Patentinhaber: Oerlikon Surface Solutions AG, Pfäffikon, 8808 Pfäffikon SZ (CH)
(72) Erfinder: KRASSNITZER, Siegfried, 6800 Feldkirch (AT); KURAPOV, Denis, 8880 Walenstradt (CH)
(74) Vertreter: Kempkens, Anke
(86) Internationale Anmeldenummer: PCT/EP2013/001914
(87) Internationale Veröffentlichungsnummer: WO 2014/008989

(56) Entgegenhaltungen:
- DE-A1-102006 061 324
- Stefan Welzel: "Untersuchungen einer gepulsten Magnetronentladung bei der Abscheidung von Oxidschichten mittels optischer Emissionsspektroskopie und elektrischer Sonden", Diplomarbeit, 29. Oktober 2004 (2004-10-29), Seiten 1-103, XP055077952, Chemnitz Gefunden im Internet: URL:http://www.qucosa.de/fileadmin/data/qu cosa/documents/4909/data/dastwel.pdf [gefunden am 2013-09-06]
- J T Gudmundsson ET AL: "High power impulse magnetron sputtering discharge", Journal of Vacuum Science & Technology A (Vacuum, Surfaces, and Films), 14. März 2012 (2012-03-14), Seite 030801 (35 pp.), XP55030718, DOI: 10.1116/1.3691832] Gefunden im Internet: URL:http://www.qucosa.de/fileadmin/data/qu cosa/documents/4909/data/dastwel.pdf [gefunden am 2012-06-22]
- SPROUL W D ET AL: "Control of reactive sputtering processes", THIN SOLID FILMS, ELSEVIER-SEQUOIA S.A. LAUSANNE, CH, Bd. 491, Nr. 1-2, 22. November 2005 (2005-11-22), Seiten 1-17, XP025388025, ISSN: 0040-6090 [gefunden am 2005-11-22]
- SARAKINOS K ET AL: "High power pulsed magnetron sputtering: A review on scientific and engineering state of the art", SURFACE AND COATINGS TECHNOLOGY, ELSEVIER, AMSTERDAM, NL, Bd. 204, Nr. 11, 25. Februar 2010 (2010-02-25), Seiten 1661-1684, XP026874007, ISSN: 0257-8972 [gefunden am 2010-01-26]
- None

## Beschreibung

Die vorliegende Erfindung bezieht sich auf ein Verfahren zur Aufbringung einer Mischkristallschicht mittel High Power Impuls Sputtering (HIPIMS), unter Verwendung von mindestens zwei Targets mit unterschiedlichen Materialien.

Werden gemäss Stand der Technik die Targets zum Abscheiden der Mischkristallschicht gleichzeitig betrieben, so ergibt sich die Problematik dass die unterschiedlichen Targets bei gleichen Prozessparametern unterschiedlich stark vergiften. Beide Targets unabhängig voneinander im jeweils gewünschten Arbeitsmodus zu halten ist dabei nicht möglich, da die Sputterquellen über das Volumen mit demselben Partialdruck des Reaktivgases verbunden sind.

Im Rahmen der vorliegenden Beschreibung werden die Begriffe "zerstäuben" und "sputtern" als identisch verstanden. Als Target wird im Rahmen der vorliegenden Beschreibung derjenige Bestandteil einer Sputterquelle bezeichnet, von welchem während des Verfahrens Material abgetragen wird.

Um Mischkristalle herzustellen werden in der Sputtertechnologie gemäss Stand der Technik Composite Targets (Verbund-Targets) eingesetzt. So ist in der DE60104709 ein Target bestehend aus einem ersten Grundmaterial und einem zweiten Material beschrieben, welches in Form von stopfen in das erste grundmaterial eingebracht ist. Eine weitere Methode zur Herstellung von Verbundtargets ist die Pressung im Pulvermetallurgischen Verfahren von zwei oder mehreren metallischen Pulvern mit Korngrössen unter 100µm.

Ein Nachteil ist dabei, dass zu Realisation unterschiedliche Konzentrationsverhältnisse in der Mischkristallschicht jeweils andere Targets eingesetzt werden müssen. Hinzu kommt das bei Schichten die derartigen Targettypen hergestellt werden die Schichtkomposition nicht mit der Ausgangskomposition des Targetmaterials übereinstimmt.

Im Stand der Technik wird gemäss einem anderen Ansatz vorgeschlagen zumindest ein Material mittels Dual Magnetron oder HIPIMS und zumindest ein zweites Material mittels Lichtbogenverdampfen gleichzeitig zu betreiben. Dementsprechend wird in der WO2011/138331 ein Verfahren zum Abscheiden von Mischkristallschichten mit wenigstens zwei verschiedenen Metallen (M1, M2) auf einem Substrat mittels PVD-Verfahren offenbart, welches dadurch gekennzeichnet ist, dass das Abscheiden der Mischkristallschicht unter gleichzeitiger Anwendung i) der Kathodenzerstäubungsverfahrens duales Magnetronsputtern oder High Power Impulse Magnetronsputtern (HIPIMS) und ii) Lichtbogenverdampfen (Arc-PVD) durchgeführt wird. Ein weiterer Stand der Technik wird beschrieben in: Stefan Welzel: "Untersuchungen einer gepulsten Magnetronentladung bei der Abscheidung von Oxidschichten mittels optischer Emissionsspektroskopie und elektrischer Sonden", Diplomarbeit, 29. Oktober 2004 (2004-10-29), Seiten 1-103, Chemnitz.

Dabei ist von Nachteil, dass aufgrund der zwei PVD-Verfahren zwei aufwändige Technologien in einer Beschichtungskammer realisiert werden müssen. Ausserdem ergeben sich in der Mischkristallschicht aufgrund des Lichtbogenverfahrens Spritzer (Droplets) welche die Schichteigenschaften wie zum Beispiel die Schichtrauhigkeit negativ beeinflussen.

Die Aufgabe der vorliegenden Erfindung besteht darin ein Verfahren anzugeben, mit welchem die oben geschilderten Probleme überwunden werden. Mit dem Verfahren gemäss unabhängigem Anspruch 1 ist es möglich mittels HIPIMS und ohne Lichtbogenverdampfen eine Mischkristallschicht zu erzeugen. Erfindungsgemäss wird dies dadurch erreicht, dass ein HIPIMS Verfahren unter Verwendung von mindestens zwei Targets mit unterschiedlichen Materialien durchgeführt wird, wobei der für das Targetmaterial jeweils geeignete Arbeitspunkt über die Leistungspulse bezgl. der Leistung und/oder Pulsdauer getrennt justiert wird.

Für ein besseres Verständnis der komplexen Vorgänge bei einem HIPIMS-Verfahren wird zunächst ein wenig mehr auf die Targetvergiftung eingegangen. Der reaktive Sputtervorgang wird durch die Reaktion der Targetoberfläche mit dem Reaktivgas wie z.B. Stickstoff oder Sauerstoff bestimmt. Dies wird als Targetvergiftung bezeichnet. Bei hohem Vergiftungsgrad der Targetoberfläche und hoher Reaktivität (z.B. Nitrierung oder Oxidation) kommt es zu einer geringen Sputterrate. Wird in diesem Fall die Sputterrate als Funktion des Reaktivgasflusses aufgetragen, so ergibt sich die dem Fachmann bekannte Hysterese.

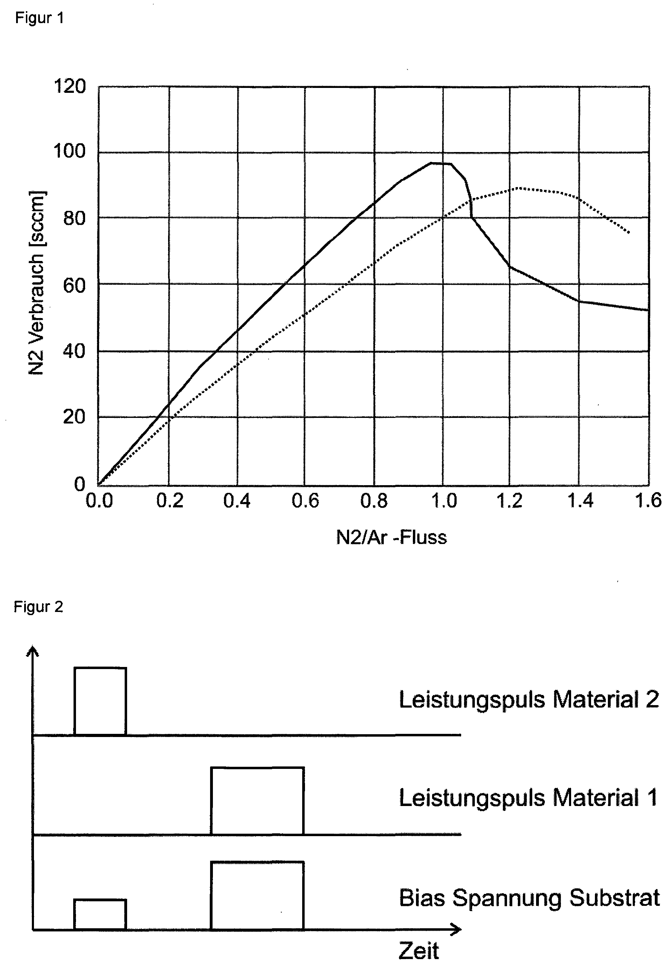

Figur 1 zeigt die Aufnahme von Stickstoff an den reaktiven Oberflächen wie Target und Schicht in Abhängigkeit des Verhältnisses von Stickstofffluss zu Argonfluss für unterschiedliche Pulsdauer. Dabei wurde der mittlere Druck und der Ar-Fluss auch konstant gehalten. Die Pulsleistung betrug 1000W/cm². Die durchgezogene Linie bezieht sich auf eine Pulsdauer von 50µs und die gepunktete Linie bezieht sich auf eine Pulsdauer von 2000µs

Die Kennlinie eines HIPIMS Prozesses mit einer Pulsdauer von 50µs zeigt bei Zugabe von Stickstoff ein vollständiges Aufzehren des eingebrachten Stickstoffes bis zu einem N2/Ar - Fluss Verhältnis von ca. 0.9. Die Stickstoffkonsumation ist in etwa proportional zur Beschichtungsrate. Ab einem Verhältnis von 1.0 und höher sinkt die Sputterrate durch die Nitrierung der Target Oberfläche stark ab. Dieser Bereich wird Übergangsbereich genannt. Er markiert den Bereich des Übergangs zu einer vergifteten Targetoberfläche. Bei weiterer Zugabe von Stickstoff nimmt die Vergiftung der Target Oberfläche zu und die Rate nähert sich einem Minimalwert.

Wird die oben genannte HIPIMS Entladung mit einer Pulsdauer von 2000µs bei sonst gleicher mittlerer Sputterleistung betrieben, so verschiebt sich der Bereich des Übergangs zu einer vergifteten Targetoberfläche hin zu höheren N2/Ar -Fluss Verhältnissen. Dies bedeutet aber, dass bei vorgegebenem N2/Ar-Fluss Verhältnis mittels Wahl der Pulsdauer eingestellt werden kann, ob mit einem Target im metallischen Modus, im vergifteten Modus oder im Übergangsbereich zerstäubt wird. D.h. mittels Pulsdauerwahl kann der Arbeitspunkt eingestellt werden. Dies eröffnet die Möglichkeit bei zwei oder mehreren Targets mit unterschiedlichen Materialien und damit unterschiedlichem Reaktionsverhalten gegenüber dem Sputtergas durch eine dem jeweiligen Targetmaterial zugeordnete Pulsdauer unabhängig voneinander in ihrem Arbeitspunkt einzustellen.

Es sei darauf hingewiesen, dass beim Pulsen mit moderaten Leistungsdichten, wie sie beim herkömmlichen Sputterverfahren eingesetzt werden. die oben beschriebene Abhängigkeit von der Pulsdauer nicht auftritt.

Figur 1 zeigt insbesondere, dass wenn der Arbeitspunkt bei einer Einstellung des Verhältnisses Reaktivgas zu Inertgas von 1.2 festgelegt wird, der HIPIMS Sputterprozess unter Verwendung einer Pulsdauer von 50µs bereits im vergifteten Modus läuft und die Beschichtungsrate um ca 30% geringer ist als die maximal erzielbare Beschichtungsrate im Übergangsbereich. Durch die Erhöhung der Pulsdauer des HIPIMS Leistungspulses bei ansonsten gleichbleibender mittlerer Sputterleistung und gleichen Prozessgas-Bedingungen liegt der mit einem Reaktivgas zu Inertgasverhältnis von 1.2 gewählte Arbeitspunkt wieder im Übergangsbereich.

Die Erfinder vermuten, dass im Rahmen des HIPIMS-Verfahrens das Energiequantum pro Leistungspuls die massgebende Rolle spielt, welches sich aus dem Produkt von Pulsleistungsamplitude und Pulsdauer ergibt. Auch die Anzahl der Pulse pro Zeiteinheit kann dabei eine Rolle spielen.

Die Erfindung wird nun im Detail anhand mehrerer Ausführungsformen beispielhaft und anhand der Figuren beschrieben.
Figur 1 zeigt den Stickstoffverbrauch in Abhängigkeit des Verhältnisses des Reaktivgas/Inertgas-Flusses für unterschiedliche Pulsdauer
Figur 2 zeigt den auf die Leistungspulse synchronisierten Substratbias
Figur 3 zeigt schematisch eine Beschichtungsanlage
Figur 4 zeigt den Stickstofffluss in Abhängigkeit vom Partialdruck
Figur 5 zeigt den Stickstoffverbrauch in Abhängigkeit vom Partialdruck
Figur 6 zeigt den Stickstoffverbrauch in Abhängigkeit vom Partialdruck für unterschiedliche Pulsleistungen
Figur 7 zeigt den Stickstoffverbrauch in Abhängigkeit vom Partialdruck für unterschiedliche Pulslängen.

Eine Beschichtungskammer in der ein erfindungsgemässes HIPIMS-Verfahren angewandt werden soll umfasst eine erste Sputterquelle Q1 mit einem ersten Target TA1 aus einem ersten zu zerstäubenden Targetmaterial und eine zweite Sputterquelle Q2 mit einem zweiten Target TA2 aus einem zweiten Targetmaterial. Im Beispiel kann das erste Target TA1 aus Aluminium und das zweite Target TA2 aus Chrom bestehen. Gemäss einer ersten Ausführungsform der vorliegenden Erfindung wird Argon und Stickstoff im Verhältnis 1:1 in die zuvor evakuierte Beschichtungskammer eingelassen. Damit erfahren die Targetoberflächen denselben Reaktiv- und Inertgas Partialdruck. Die an den Targets anliegende Leistungsdichte in den Pulsen wird auf 1000W/cm² festgelegt. Die Pulsdauern (t1, t2) wird individuell pro Target so festgelegt, dass der Arbeitspunkt jeweils im Übergangsbereich liegt. Der Füllfaktor D, d.h. das Verhältnis zwischen Pulsdauer und Wiederholintervall (= Zeitintervall vom Anfang eines Pulses an einem Target bis zum Anfang des nächsten Pulses am selben Target) wird für beide Targets gleich gewählt. Damit ergibt sich eine an den Targets anliegende unterschiedliche mittlere Leistung. Aufgrund der hohen Leistungsdichte kommt es zu einem hohen ionisierten Anteil des zerstäubten Materials. Wird an die zu beschichtenden Substrate ein negativer Bias angelegt, so führt dies zu dichten, glatten Schichten.

Gemäss eine zweiten Ausführungsform der vorliegenden Erfindung werden anders als gemäss der ersten Ausführungsform die an den Targets anliegenden Leistungsdichten und/oder die Füllfaktoren individuell eingestellt.

Wie dem Fachmann unschwer erkennbar spielt bei dem erfindungsgemässen Verfahren die Möglichkeit der kontrollierten Bereitstellung von Pulsen hoher Leistungsdichte mit vorgegebenem Pulsprofil eine wichtige Rolle. Sofern es die Leistungsquelle gestattet, können die Pulse an den Targets völlig unabhängig vom jeweils anderen Target angelegt werden. Dies insbesondere dann, wenn jedem Target eine separate Leistungsquelle zugeordnet ist. Dabei können leistungsstarke DC-Generatoren verwendet werden, die für die Pulsdauer ihre Leistung an das jeweils zugeordnete Target abgeben, für die restliche Zeit ihre Leistung an eine sogenannte Leistungssenke (im Folgenden Dummy Load genannt) abgeben. Die Leistungsabgabe an ein Dummy Load macht besonders beim Beginn der Leistungsabgabe Sinn, da diese einer durch den Generator bestimmten Aufbaucharakteristik folgt. Die Verwendung mehrerer Generatoren hat den Nachteil, dass ein Grossteil der Leistung, nämlich derjenige Teil, welcher auf die Dummy Loads gelenkt wird, schlichtweg nicht genutzt wird

Gemäss einem neuen Verfahren kann hierzu beispielsweise ein leistungsstarker DC-Generator verwendet werden, dessen Leistung mithilfe von Schaltern sequenziell und bevorzugt ohne Unterbrechung der Leistungsabgabe auf die unterschiedlichen Targets appliziert wird. Am Ender des Pulsinterwals wird die Leistung dann einfach auf das Target umgeschalten. Wiederum kann es sinnvoll sein die anfangs und/oder zwischenzeitlich auch auf einen Targetersatz (Dummy Load) umzulenken. Der Leistungsverlust an der Dummy Load ist aber dadurch, dass sequenziell mehrere Targets beaufschlagt werden sehr stark reduziert.

Werden die Targets sequenziell mit Leistungspulsen beaufschlagt so besteht die Möglichkeit gemäss einer besonders bevorzugten Ausführungsform den an die Substrate angelegten Bias mit der Pulsfolge zu synchronisieren und individuell für ein Target und damit für ein Schichtmaterial einen spezifisch gewählten Substratspannungspuls anzulegen. Somit kann beispielsweise für Targetmaterial 1 eine andere Substratbiasspannung und damit Beschleunigung der Ionen erfolgen als für Targetmaterial 2. Die entsprechende Situation ist in Figur 2 dargestellt.

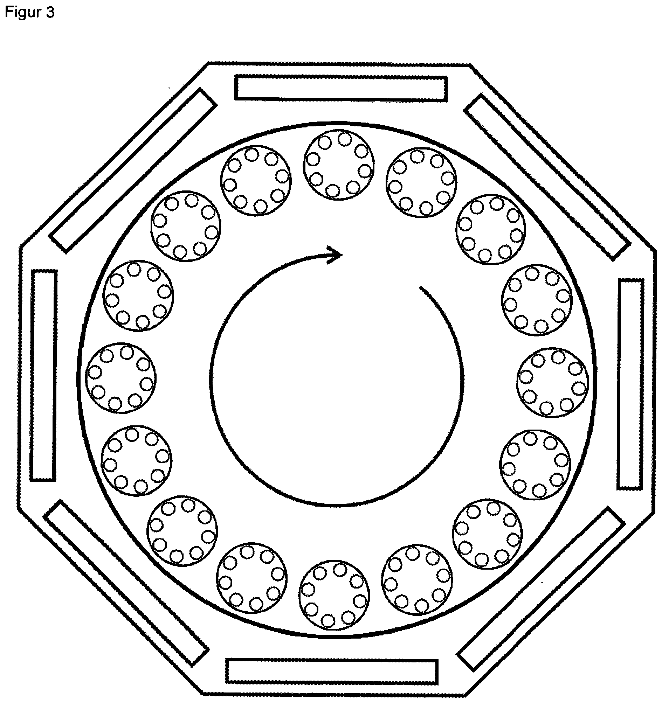

Häufig sind Beschichtungsanlagen als Batchanlagen ausgeführt, in der an den Kammerwänden die verschiedenen Beschichtungsquellen angeordnet sind. Die zu beschichtenden Substrate werden dann in einem sogenannten Karussell in Werkstückträgern angeordnet und aufgrund der Rotation des Karussells periodisch an den Beschichtungsquellen vorbei geführt. Eine dementsprechende Situation ist beispielhaft und schematisch in Figur 3 dargestellt. Mit einem solchen Aufbau kann es vorkommen, dass die dabei entstehende Schicht nicht als homogener Mischkristall abgeschieden wird sondern sogenannte Nanolagen entstehen wobei sich von einer Nanolage zu den benachbarten die Schichtzusammensetzung ändert. Da sich, wie oben diskutiert, über die Pulslänge die Beschichtungsrate individuell einstellen lässt, können erfindungsgemäss in einfacher Weise die Dicken der unterschiedlichen Nanolagen relativ zueinander eingestellt werden.

Gemäss einer weiteren Ausbildungsform der vorliegenden Erfindung wird noch direkter auf den Verbrauch des Reaktivgases abgestellt. Erfindungsgemäss wird dabei der Stickstoffpartialdruck in der Kammer erhöht und dabei gemessen, wie stark hierzu der Stickstofffluss erhöht werden muss. Diese Messung wird einmal ohne gezündetes Plasma und einmal mit gezündetem Plasma durchgeführt.

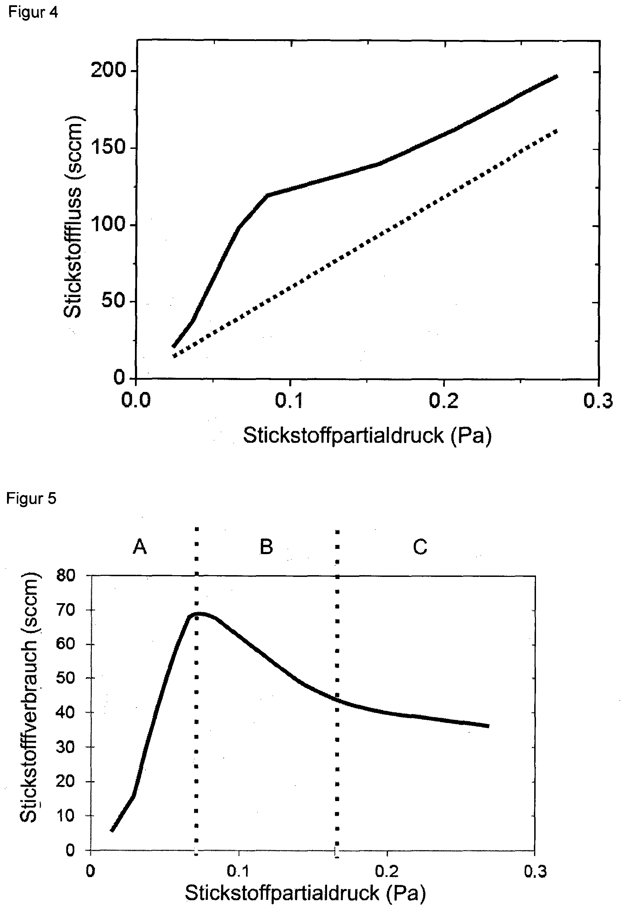

Figur 4 stellt entsprechend die Abhängigkeit des Stickstoffflusses vom Partialdruck in der Kammer dar. Die gestrichelte Linie bezieht sich dabei auf die Abhängigkeit ohne gezündetes Plasma, die durchgestrichene Linie bezieht sich auf die Abhängigkeit mit gezündetem Plasma. Im vorliegenden Beispiel wurde ein Puls von 200µs bei einer Leistungsdichte im Puls von 1000W/cm² verwendet.

Wird nun die untere Kurve von der oberen Kurve abgezogen, so ergibt sich ein Mass vor den Stickstoffverbrauch in Abhängigkeit des Stickstoff-Partialdrucks. Dies ist in Figur 5 dargestellt. Ebenfalls eingezeichnet sind drei Bereiche, nämlich der metallische Modus A, der Übergangsmodus B und der vergiftete Modus C. Erfindungsgemäss wird im Übergangsmodus B gearbeitet. Entsprechend wird der Partialdruck in einem Bereich eingestellt, dessen Untergrenze zu einem maximalen Stickstoffverbrauch führt und dessen Obergrenze zu 70% des maximalen Stickstoffverbrauchs führt.

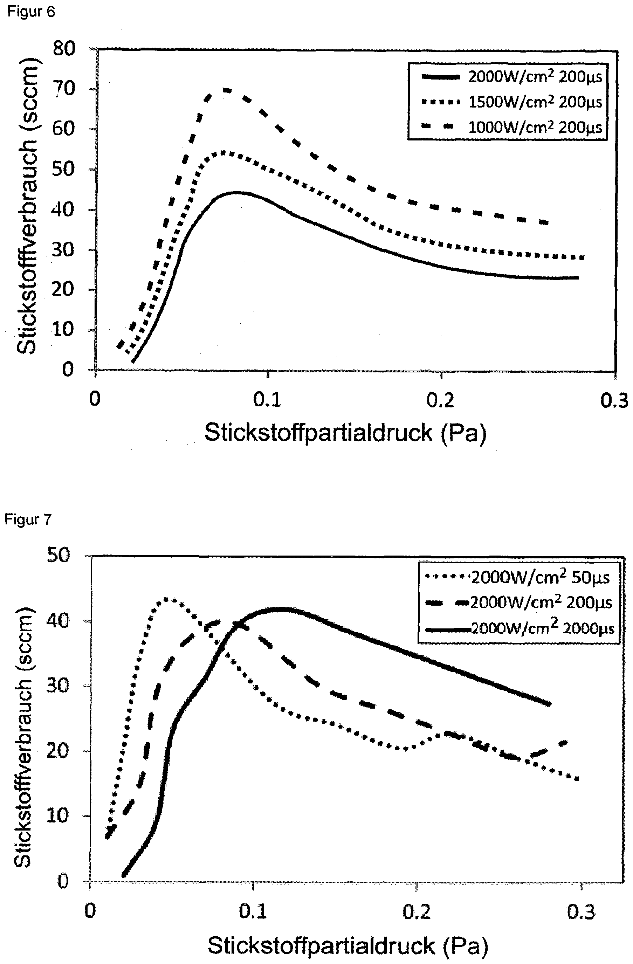

Die Erfinder haben nun festgestellt, dass die Höhe des maximalen Stickstoffverbrauch im Wesentlichen von der Leistungsdichte im Puls abhängt, wie in Figur 6 dargestellt und die Lage des maximalen Stickstoffverbrauchs im Wesentlichen von der Pulsdauer der Pulse abhängt, wie in Figur 7 dargestellt.

Figur 6 zeigt dass es mit höherer Leistungsdichte im Puls im Übergangsbereich zu einer Abflachung der Abhängigkeit des Stickstoffverbrauchs vom Partialdruck kommt. Figur 7 zeigt, dass sich mit Erhöhung der Pulsdauer die Abhängigkeit noch flacher wird. D.h. bei Erhöhung der Pulsleistung und/oder Erhöhung der Pulsdauer wird der Beschichtungsprozess stabiler da weniger abhängig vom spezifischen Partialdruck.

Es wurde ein Verfahren zur Ermittlung des Reaktivgasverbrauchs in einem Beschichtungsprozess mittels Plasma vorgestellt mit folgenden Schritten:
a) Einlass von Reaktivgas in eine Beschichtungskammer wobei der entsprechende Reaktivgasfluss gemessen wird und gleichzeitig der in der Beschichtungskammer vorherrschende Partialdruck gemessen wird, ohne ein Plasma zu zünden
b) Einlass von Reaktivgas in eine Beschichtungskammer wobei der entsprechende Reaktivgasfluss gemessen wird und gleichzeitig der in der Beschichtungskammer vorherrschende Partialdruck gemessen wird, wobei ein Plasma gezündet ist,
dadurch gekennzeichnet, dass
- Schritte a) und b) bei mehreren unterschiedlichen Reaktivgasflüssen durchgeführt werden und so die Reaktivgasfluss - Partialdruckabhängigkeit sowohl mit Plasma als auch ohne Plasma ermittelt werden kann
- bei gegebenem Partialdruck Abzug des Reaktivgasflusswertes der ohne Plasma ermittelt wurde vom Reaktivgasflusswert der mit Plasma ermittelt wurde und Gleichsetzung der Differenz mit dem Reaktivgasverbrauch.

Dabei kann die "Messung des Partialdrucks" beispielsweise indirekt dadurch vorgenommen werden dass der in der Beschichtungskammer vorherrschende Gesamtdruck gemessen wird und von diesem der Partialdruck des Arbeitsgases abgezogen wird.

Es wurde ausserdem ein Verfahren zum Beschichten von Substraten mittels reaktivem plasmaunterstütztem HiPIMS Sputterprozess beschrieben, bei dem zunächst der Reaktivgasverbrauch in Abhängigkeit einer oder mehrerer Beschichtungsparameter ermittelt wird und für die Beschichtung die Beschichtungsparameter so gewählt werden dass die Beschichtung im Übergangsmodus durchgeführt wird.

Das Verfahren kann dadurch gekennzeichnet, dass zur Ermittlung des Reaktivgasverbrauchs das oben beschriebene Verfahren angewendet wird.

## Patentansprüche

1. Verfahren zum Beschichten von Substraten mittels reaktivem plasmaunterstütztem HiPIMS Sputterprozess, wobei zunächst der Reaktivgasverbrauch in Abhängigkeit eines Beschichtungsparameters ermittelt wird und für die Beschichtung die Beschichtungsparameter so gewählt wird, dass die Beschichtung im Übergangsmodus durchgeführt wird, **dadurch gekennzeichnet, dass**
• der Reaktivgasverbrauch durch die Einstellung des besagten Beschichtungsparameters reguliert wird, wobei der besagte Beschichtungsparameter der Reaktivgaspartialdruck ist,
• um im Übergangsmodus zu arbeiten, der Reaktivgaspartialdruck in einem Bereich eingestellt wird, dessen Untergrenze zu dem maximalen Reaktivgasverbrauch führt und dessen Obergrenze zu 70% des maximalen Reaktivgasverbrauchs führt,
wobei:
• der HiPIMS Prozess unter Verwendung von mindestens zwei Targets mit unterschiedlichen Materialien durchgeführt wird, und
- der Arbeitspunkt für das jeweilige Targetmaterial jeweils getrennt über die Pulsdauer justiert wird.

2. Verfahren nach Anspruch 1, **dadurch gekennzeichnet, dass** zur Ermittlung der Abhängigkeit des Reaktivgasverbrauchs vom Reaktivgaspartialdruck ein Verfahren mit folgenden Schritten durchgeführt wird:
a) Einlass von Reaktivgas in eine Beschichtungskammer wobei der entsprechende Reaktivgasfluss gemessen wird und gleichzeitig der in der Beschichtungskammer vorherrschende Reaktivgaspartialdruck gemessen wird, ohne ein Plasma zu zünden,
b) Einlass von Reaktivgas in eine Beschichtungskammer wobei der entsprechende Reaktivgasfluss gemessen wird und gleichzeitig der in der Beschichtungskammer vorherrschende Reaktivgaspartialdruck gemessen wird, wobei ein Plasma gezündet ist,
c) Wiederholung der Schritte a) und b) bei mehreren unterschiedlichen Reaktivgasflüssen und Ermittlung der Reaktivgasfluss - Partialdruckabhängigkeit sowohl mit Plasma als auch ohne Plasma,
d) bei gegebenem Partialdruckabzug des Reaktivgasflusswertes, der ohne Plasma ermittelt wurde, vom Reaktivgasflusswert, der mit Plasma ermittelt wurde, und Gleichsetzung der Differenz mit dem Reaktivgasverbrauch.

3. Verfahren nach einem der vorangehenden Ansprüche 1 bis 2, **dadurch gekennzeichnet, dass** die Messung des Reaktivgaspartialdrucks indirekt dadurch vorgenommen wird, dass der in der Beschichtungskammer vorherrschende Gesamtdruck gemessen wird und von diesem der Partialdruck des Arbeitsgases abgezogen wird.

4. Verfahren nach einem der vorangehenden Ansprüche 1 bis 3, **dadurch gekennzeichnet, dass** Stickstoffgas als Reaktivgas verwendet wird.

## Claims

1. Method for coating substrates by means of a reactive plasma-assisted HiPIMS sputtering process, wherein first the reactive gas consumption is determined as a function of a coating parameter and for coating the coating parameters are selected in such a way that the coating takes place in a transition mode, **characterized in that:**
• the reactive gas consumption is regulated by setting said coating parameter, wherein said coating parameter is the reactive gas partial pressure,
• in order to work in the transition mode the reactive gas partial pressure is set in a range the lower limit of which leads to the maximum reactive gas consumption and the upper limit of which leads to 70% of the maximum reactive gas consumption,
wherein:
• the HiPIMS process is carried out by using at least two targets made of different materials, and
• the working point for the respective target material is adjusted separately over the pulse duration.

2. The method according to claim 1, **characterized in that** for determining the dependence of the reactive gas consumption on the reactive gas partial pressure, a method comprising the following steps is carried out:
a) admitting reactive gas into a coating chamber, wherein the corresponding reactive gas flow is measured and, at the same time, the reactive gas partial pressure prevailing in the coating chamber is measured, without igniting a plasma;
b) admitting reactive gas into the coating chamber, wherein the corresponding reactive gas flow is measured and, at the same time, the reactive gas partial pressure prevailing in the coating chamber is measured, wherein a plasma is ignited;
c) repeating the steps a) and b) in the case of a plurality of different reactive gas flows and determining the partial pressure dependence of the reactive gas flow both with plasma and without plasma, and
d) in the case of a given partial pressure, deducting of the reactive gas flow value that has been determined without plasma from the reactive gas flow value that has been determined with plasma and equating the difference to the reactive gas consumption.

3. The method according to one of the preceding claims 1 to 2, **characterized in that** the reactive gas partial pressure is indirectly measured by measuring the total pressure prevailing in the coating chamber and deducting the partial pressure of the working gas from it.

4. The method according to one of the preceding claims 1 to 3, **characterized in that** nitrogen gas is used as reactive gas.

## Revendications

1. Procédé de revêtement de substrats au moyen d'un procédé de pulvérisation HiPIMS réactif et assisté par plasma dans lequel d'abord la consommation de gaz réactif est déterminée en fonction d'un paramètre de revêtement et pour le revêtement le paramètre de revêtement est choisi de telle manière que le revêtement est effectué en mode de transition, **caractérisé en ce que**
• la consommation de gaz réactif est régulée en ajustant ledit paramètre de revêtement, ledit paramètre de revêtement étant la pression partielle de gaz réactif,
• pour travailler en mode de transition, la pression partielle de gaz réactif est ajustée dans une plage dont la limite inférieure conduit à la consommation maximale de gaz réactif et dont la limite supérieure conduit à 70% de la consommation maximale de gaz réactif,
dans lequel :
• le procédé HiPIMS est exécuté en utilisant au moins deux cibles de différents matériaux, et
• le point de travail est ajusté séparément pour le matériau de cible respectif pendant la durée d'impulsion.

2. Le procédé selon la revendication 1, **caractérisé en ce que**, pour déterminer la dépendance de la consommation de gaz réactif à l'égard de la pression partielle de gaz réactif, un procédé avec les étapes suivantes est exécuté:
a) admission de gaz réactif dans une chambre de revêtement, le débit de gaz réactif correspondant étant mesuré et, en même temps, la pression partielle de gaz réactif qui règne dans la chambre de revêtement étant mesurée sans allumer un plasma,
b) admission de gaz réactif dans une chambre de revêtement, le débit de gaz réactif correspondant étant mesuré et, en même temps, la pression partielle de gaz réactif qui règne dans la chambre de revêtement étant mesurée, en allumant un plasma,
c) répétition des étapes a) et b) avec plusieurs débits de gaz réactif différents et détermination de la dépendance du débit de gaz réactif à l'égard de la pression partielle à la fois avec plasma et sans plasma,
d) dans le cas d'une pression partielle donnée, soustraire la valeur du débit de gaz réactif qui a été déterminée sans plasma de la valeur du débit de gaz réactif qui a été déterminée avec plasma et assimiler la différence à la consommation de gaz réactif.

3. Le procédé selon l'une des revendications 1 à 2, **caractérisé en ce que** la pression partielle de gaz réactif est mesurée indirectement en mesurant la pression totale régnant dans la chambre de revêtement et soustrayant la pression partielle du gaz de travail de celle-ci.

4. Le procédé selon l'une des revendications 1 à 3, **caractérisé en ce que** l'azote gazeux est utilisé comme gaz réactif.
